# EUROPEAN PATENT SPECIFICATION

(11) **EP 0 998 592 B1**
(45) Date of publication and mention of the grant of the patent: **28.02.2007**
(21) Application number: 98934538.4
(22) Date of filing: 15.07.1998
(51) Int. Cl.: C23C 2/00, H01L 21/285, C23C 14/00, C23C 14/18

(54) **METHOD OF USING HYDROGEN AND OXYGEN GAS IN SPUTTER DEPOSITION OF ALUMINUM-CONTAINING FILMS AND ALUMINUM-CONTAINING FILMS DERIVED THEREFROM**
VERFAHREN ZUR BENUTZUNG VON WASSERSTOFF- UND SAUERSTOFFGAS IN SPUTTERABSCHEIDUNG VON ALUMINIUMHALTIGEN FILMEN UND DANACH HERGESTELLTE ALUMINIUMHALTIGE FILME
PROCEDE D'UTILISATION D'HYDROGENE ET D'OXYGENE GAZEUX POUR DEPOSER DES FILMS A BASE D'ALUMINIUM PAR PULVERISATION CATHODIQUE, ET FILMS A BASE D'ALUMINIUM AINSI OBTENUS

(30) Priority: 15.07.1997 US 892930; 15.07.1997 US 892718
(43) Date of publication of application: 10.05.2000
(60) Divisional application: 03022482.8
(73) Proprietor: MICRON TECHNOLOGY, INC., Boise, ID 83706-9632 (US)
(72) Inventor: RAINA, Kanwal, K., Boise, ID 83716 (US); WELLS, David, H., Boise, ID 83706 (US)
(74) Representative: Gerbino, Angelo
(86) International application number: PCT/US1998/014578
(87) International publication number: WO 1999/004054

(56) References cited:
- EP-A- 0 352 333
- EP-A- 0 855 451
- US-A- 3 717 564
- US-A- 4 302 498
- US-A- 5 367 179
- US-A- 6 057 238

## Description

### TECHNICAL FIELD

This invention relates generally to an aluminum-containing film deposited onto a semiconductor substrate, such as a silicon wafer. More particularly, the invention relates to using a hydrogen gas/oxygen gas mixture with argon during the deposition of aluminum or aluminum alloys to form an aluminum-containing film which is resistant to hillock formation.

### BACKGROUND ART

Thin film structures are becoming prominent in the circuitry components used in integrated circuits ("ICs") and in active matrix liquid crystal displays ("AMLCDs"). In many applications utilizing thin film structures, low resistivity of metal lines (gate lines and data lines) within those structures is important for high performance. For example with AMLCDs, low resistivity metal lines minimize RC delay which results in faster screen refresh rates. Refractory metals, such as chromium (Cr), molybdenum (Mo), tantalum (Ta), and tungsten (W), have resistances which are too high for use in high performance AMLCDs-or ICs.

Additionally, the cost of refractory metals is greater than non-refractory metals. From the standpoint of low resistance and cost, aluminum (Al) is a desirable metal. Furthermore, aluminum is advantageous because it forms an oxidized film on its outer surfaces which protects the aluminum from environmental attack, and aluminum has good adhesion to silicon and silicon compounds.

An aluminum film is usually applied to a semiconductor substrate using sputter deposition. Sputter deposition is generally performed inside the vacuum chamber where a solid slab (called the "target") of the desired film material, such as aluminum, is mounted and a substrate is located. Argon gas is introduced into the vacuum chamber and an electrical field is applied between the target and the substrate which strikes a plasma. In the plasma, gases are ionized and accelerated, according to their charge and the applied electrical field, toward the target. As the argon atoms accelerate toward the target, they gain sufficient momentum to knock off or "sputter" atoms and/or molecules from the target's surface upon impact with the target. After sputtering the atoms and/or molecules from the target, the argon ions, the sputtered atoms/molecules, argon atoms and electrons generated by the sputtering process, form a plasma region in front of the target before coming to rest on the semiconductor substrate, which is usually positioned below or parallel to the target within the vacuum chamber. However, the sputtered atoms and/or molecules may scatter within the vacuum chamber without contributing to the establishment of the plasma region and thus not deposit on the semiconductor substrate. This problem is at least partly resolved with a "magnetron sputtering system" which utilizes magnets behind and around the target. These magnets help confine the sputtered material in the plasma region. The magnetron sputtering system also has the advantage of needing lower pressures in the vacuum chamber than other sputtering systems. Lower pressure within the vacuum chamber contributes to a cleaner deposited film. The magnetron sputtering system also results in a lower target temperature, which is conducive to sputtering of low melt temperature materials, such as aluminum and aluminum alloys.

Although aluminum films have great advantages for use in thin film structures, aluminum has an unfortunate tendency to form defects, called "hillocks." Hillocks are projections that erupt in response to a state of compressive stress in a metal film and consequently protrude from the metal film surface.

There are two reasons why hillocks are an especially severe problem in aluminum thin films. First, the coefficient of thermal expansion of aluminum (approximately 23.5x10⁻⁶/°C.) is almost ten times as large as that of a typical silicon semiconductor substrate (approximately 2.5x10⁻⁶/°C.). When the semiconductor substrate is heated during different stages of processing of a semiconductor device, the thin aluminum film, which is strongly adhered to the semiconductor substrate, attempts to expand more than is allowed by the expansion of the semiconductor substrate. The inability of the aluminum film to expand results in the formation of the hillocks to relieve the expansion stresses. The second factor involves the low melting point of aluminum (approximately 660°C.), and the consequent high rate of vacancy diffusion in aluminum films. Hillock growth takes place as a result of a vacancy-diffusion mechanism. Vacancy diffusion occurs as a result of the vacancy-concentration gradient arising from the expansion stresses. Additionally, the rate of diffusion of the aluminum increases very rapidly with increasing temperature. Thus, hillock growth can thus be described as a mechanism that relieves the compressive stress in the aluminum film through the process of vacancy diffusion away from the hillock site, both through the aluminum grains and along grain boundaries. This mechanism often drives up resistance and may cause open circuits.

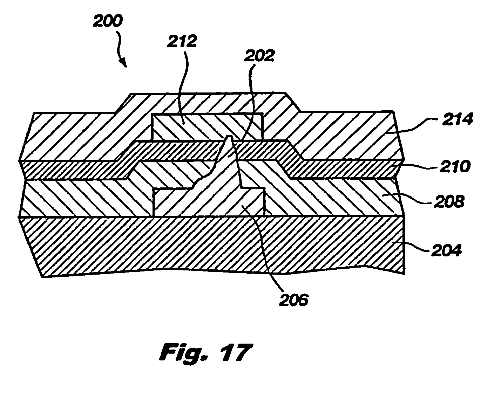

A hillock-related problem in thin film structure manufacturing occurs in multilevel thin film structures. In such structures, hillocks cause interlevel shorting when they penetrate or punch through a dielectric layer separating overlying metal lines. This interlevel shorting can result in a failure of the IC or the AMLCD. Such a shorted structure is illustrated in FIG. 17.

FIG. 17 illustrates a hillock 202 in a thin film structure 200. The thin film structure 200 comprises a semiconductor substrate 204, such as a silicon wafer, with a patterned aluminum layer 206 thereon. A lower dielectric layer 208, such as a layer of silicon dioxide or silicon nitride, is deposited over the semiconductor substrate 204 and the patterned aluminum layer 206. The lower dielectric layer 208 acts as an insulative layer between the patterned aluminum layer 206 and an active layer 210 deposited over the lower dielectric layer 208. A metal line 212 is patterned on the active layer 210 and an upper dielectric layer 214 is deposited over the metal line 212 and the active layer 210. The hillock 202 is shown penetrating through the lower dielectric layer 208 and the active layer 210 to short with the metal line 212.

Numerous techniques have been tried to alleviate the problem of hillock formation, including: adding elements, such as tantalum, cobalt, nickel, or the like, that have a limited solubility in aluminum (however, this generally only reduces but not eliminates hillock formation); depositing a layer of tungsten or titanium on top or below the aluminum film (however, this requires additional processing steps); layering the aluminum films with one or more titanium layers (however, this increases the resistivity of the film); and using hillock resistant refractory metal films such as tungsten or molybdenum, rather than aluminum (however, as previously mentioned, these refractory metals are not cost effective and have excessive resistivities for use in high performance ICs and AMLCDs).

In particular with AMLCDs, and more particularly with thin film transistor-liquid crystal displays ("TFT-LCDs"), consumer demand is requiring larger screens, higher resolution, and higher contrast. As TFT-LCDs are developed in response to these consumer demands, the need for metal lines which have low resistivity and .. high resistance to hillock formation becomes critical.

Therefore, it would be advantageous to develop an aluminum-containing material which is resistant to the formation of hillock and technique for forming of a film of the aluminum-containing film on a semiconductor substrate which is substantially free from hillocks, while using inexpensive, commercially-available, widely-practiced semiconductor device fabrication techniques and apparatus without requiring complex processing steps.

US-A-4 302 498 discloses a laminated conducting film that is formed on an integrated circuit substrate in a vacuum chamber. The laminated conducting film includes alternating layers of aluminum and oxygen-doped aluminum. The aluminum layers are formed by evaporation or sputtering. Oxygen is periodically introduced into the vacuum chamber to form the oxygen-doped aluminum layers, which include no more than 10 atomic percent oxygen.

EP-A-0 855 451 discloses a wiring film formed from 0.001 to 30 atomic % of an intermetallic compound of aluminum and 0.01 to 50 atomic % of a carbon, hydrogen, oxygen, or nitrogen compound. The balance of the wiring film is aluminum. The wiring film is used in an electronic device, such as a liquid crystal display.

US-A-3 631 304 discloses an aluminum-aluminum oxide alloy that includes from 0.01% to 17% aluminum oxide. The alloy is used to interconnect regions or devices in a monolithic integrated semiconductor structure.

### DISCLOSURE OF INVENTION

The present invention relates to a semiconductor device, a film and a flat panel display having the features disclosed. in the claims which follow.

The aluminum-containing films of the invention have an average oxygen content between about 12 and 30% (atomic) oxygen in the form of aluminum oxide (Al₂O₃) with the remainder being aluminum. The aluminum-containing films exhibit golden-yellow color when formed under the process parameters described.

The most compelling attribute of the aluminum-containing films is that they are hillock-free, even after being subjected to thermal stresses. Although the precise mechanical and/or chemical mechanism for forming these aluminum-containing films is not completely understood, it appears that the hydrogen gas functions in the manner of a catalyst for delivering oxygen into the aluminum-containing films.

As stated previously, oxygen is present in the deposited aluminum-containing film in the form of aluminum oxide. However, aluminum oxide is an insulator. It is counter-intuitive to form an insulative compound (which should increase the resistivity of the film) in a film which requires very low resistivity. However, it has been found that the formation of the aluminum oxide does not interrupt the conducting matrix of aluminum grains within the aluminum-containing film. Thus, the resistivity of the aluminum-containing film is surprisingly low. In fact, for aluminum-containing films formed by the second method, the resistivity is in the order of between about 6 and 10 micro ohm-cm. This is particularly striking in light of the fact that aluminum oxide is present in the range of between about 12 and 30% (atomic). The grain size of these aluminum-containing films is between about 400 and 600 angstroms (Å).

Aside from being substantially hillock-free and having a low resistivity (i.e., high conductivity), the resultant aluminum-containing films have additional desirable properties including low roughness, low residual stress, and good mechanical strength (as determined by a simple scratch test compared to pure aluminum or by the low compressive stress (between about -5x10⁸ and -1x10⁹ dyne/cm²), which is considered to be an indication of high scratch resistance). Measurements of the aluminum-containing films have shown that the roughness before and after annealing is low compared to pure aluminum (about 600-1000 Å before annealing and 400-550 Å after annealing). Low roughness prevents stress migration, prevents stress-induced voids, and, consequently, prevents hillock formation. Additionally, low roughness allows for better contact to other thin films and widens the latitude of subsequent processing steps, since less rough films result in less translation of crests and valleys in the film layers deposited thereover, less diffuse reflectivity which make photolithography easier, no need to clad the aluminum in the production of AMLCDs (rough aluminum traps charge which effects electronic performance [i.e., high or variable capacitance]), and more uniform etching.

The mechanical strength of the aluminum-containing films of the invention is higher than conventionally sputtered thin films of aluminum and some of its alloys. A high mechanical strength results in the resulting aluminum-containing films being resistant to both electromigration and stress induced voiding.

This combination of such properties is superior to that of thin films of aluminum and its alloys which are presently known. These properties make the aluminum-containing films of the present invention desirable for electronic device interconnects. These properties are also desirable in thin films for optics, electro-optics, protective coatings, and ornamental applications.

### BRIEF DESCRIPTION OF DRAWINGS

While the specification concludes with claims particularly pointing out and distinctly claiming that which is regarded as the present invention, the advantages of this invention can be more readily ascertained from the following description of the invention when read in conjunction with the accompanying drawings in which:
FIGS. 1 and 2 are illustrations of scanning electron micrographs of an aluminum thin film produced by a prior art method before annealing and after annealing, respectively;
FIGS. 3 and 4 are illustrations of scanning electron micrographs of an aluminum thin film not according to the present invention before annealing and after annealing, respectively;
FIGS. 5 and 6 are illustrations of scanning electron micrographs of an aluminum thin film not according to the present invention before annealing and after annealing, respectively,
FIG. 7 is an x-ray photoelectron spectroscopy graph showing the oxygen content through the depth of an aluminum-containing film not according to the present invention;
FIG. 8 is a graph of roughness measurements (by atomic force microscopy) of various aluminum-containing films not in accordance with the present invention;
FIGS. 9 and 10 are illustrations of scanning electron micrographs of an aluminum thin film according to the present invention before annealing and after annealing, respectively;
FIGS. 11 and 12 are illustrations of scanning electron micrographs of an aluminum thin film according to the present invention before annealing and after annealing, respectively;
FIG. 13 is an x-ray photoelectron spectroscopy graph showing the oxygen content through the depth of an aluminum-containing film according to the present invention;
FIG. 14 is a graph of roughness measurements (by atomic force microscopy) of various aluminum-containing films according to the present invention;
FIG. 15 is a cross-sectional side view illustration of a thin film transistor utilizing a gate electrode and source/drain electrodes formed from an aluminum-containing film according to the present invention;
FIG. 16 is a schematic of a standard active matrix liquid crystal display layout utilizing columns buses and row buses formed from an aluminum-containing film according to the present invention; and
FIG. 17 is a cross-sectional side view illustration of interlevel shorting resulting from hillock formation.

### BEST MODE FOR CARRYING OUT THE INVENTION

A method of producing films not according to the present invention preferably involves using a conventional magnetron sputter deposition chamber within the following process parameters:

| | |
|---|---|
| Power (DC): | between about 1 and 4 KW |
| Pressure: | between about 1,0 and 2.5 millitorr |
| Argon Gas Flow Rate: | between about 50 and 90 sccm |
| Hydrogen Gas Flow Rate: | between about 90 and 600 sccm |
| Argon:Hydrogen Gas Ratio: | between about 1:1 to 1:6 |

The operation of the magnetron sputter deposition chamber generally involves applying the direct current power between the cathode (in this case the aluminum target) and the anode (substrate) to create the plasma. The chamber is maintained within the above pressure range and an appropriate mixture of argon gas and hydrogen gas. The aluminum-containing films resulting from this method have between about a trace amount and 12% (atomic) oxygen in the form of aluminum oxide (Al₂O₃) with the remainder being aluminum.

It is believed that the primary hillock prevention mechanism is the presence of the hydrogen in the system, since it has been found that even with no oxygen or virtually no oxygen present (trace amount that are unmeasurable by present equipment and techniques) results in a hillock-free aluminum-containing film. It is also believed that the presence of oxygen in the film is primarily responsible for a smooth (less rough) aluminum-containing film, since roughness generally decreases with an increase in oxygen content in the film.

It is understood that the sputter deposition system will usually always have a trace amount of oxygen. This trace amount of oxygen will be incorporated into the aluminum containing film in the presence of hydrogen, even though the very low amount of oxygen within the aluminum film cannot be detected by present analysis equipment. This trace amount of oxygen may come from two potential sources: incomplete chamber evacuation and/or inherent trace oxygen contamination in the argon or hydrogen gas feeds. The first source, incomplete chamber evacuation, comes from the fact that no vacuum is a prefect vacuum; There will also be some residual gas in the system, whether a purge gas or atmospheric gas, no matter how extreme the vacuum evacuation. The second source is a result of inherent trace gas contamination in industrial grade gases, such as the argon and hydrogen used in the present invention. The oxygen impurity content specification for the argon gas used is 1 ppm and the hydrogen gas is 3 ppm. Thus, a high flow rate of the argon and hydrogen into the system will present more trace oxygen to be scavenged from the gas streams and integrated into the aluminum-containing film. Therefore, even though present equipment cannot measure the content of the oxygen in the aluminum-containing film when it exists below 0.1 %, a trace amount below 0.1 % may be incorporated into the aluminum-containing film.

### EXAMPLE 1 (NOT OF THE INVENTION)

A control sample of an aluminum film coating on a semiconductor substrate was formed in a manner exemplary of prior art processes (i.e., no hydrogen gas present) using a Kurdex - DC sputtering system to deposit aluminum from an aluminum target onto a soda-lime glass substrate.

The substrate was loaded in a load lock chamber of the sputtering system and evacuated to about 5x10⁻³ torr. The load lock was opened and a main deposition chamber was evacuated to about 1 10⁻⁷ torr before the substrate was moved into the main deposition chamber for the sputtering process. The evacuation was throttled and specific gases were delivered into the main deposition chamber. In the control deposition, argon gas alone was used for sputtering process. Once a predetermined amount of argon gas stabilized (about 5 minutes) in the main deposition chamber, about 2 kilowatts of direct current power was applied between a cathode (in this case the aluminum target) and the anode (substrate) to create the plasma, as discussed above. The substrate was moved in front of the plasma from between about 8 and 10 minutes to form an aluminum-containing film having a thickness of about 1800 angstroms.

Table 1 discloses the operating parameters of the sputtering equipment and the characteristics of the aluminum film formed by this process.

**TABLE 1**

| **Sputtering Process Parameters** | **Control Sample** |
|---|---|
| Power (KW) | 2 |
| Pressure (mtorr) | 2.05 |
| Gas Flow (sccm) | Argon = 90 |

| **Characterization Parameters and Properties** | |
|---|---|
| Thickness (Å) | 1800 |
| Stress (dyne/cm²) (compressive) | -4.94x10⁸(C) |
| Roughness (Å) | 1480 (unannealed) |
| | 2040 (annealed) |
| Resistivity (ΦΩ-cm) | approx. 2.7 |
| Grain Size (Å) | 1000-1200 |
| Hillock Density | approx. 2 to 5×10⁹/m² |

The measurements for the characterization parameters and properties were taken as follows: thickness - Stylus Profilometer and scanning electron microscopy; stress - Tencor FLX using laser scanning; roughness - atomic force microscopy; resistivity - two point probe; grain size - scanning electron microscopy; and hillock density - scanning electron microscopy.

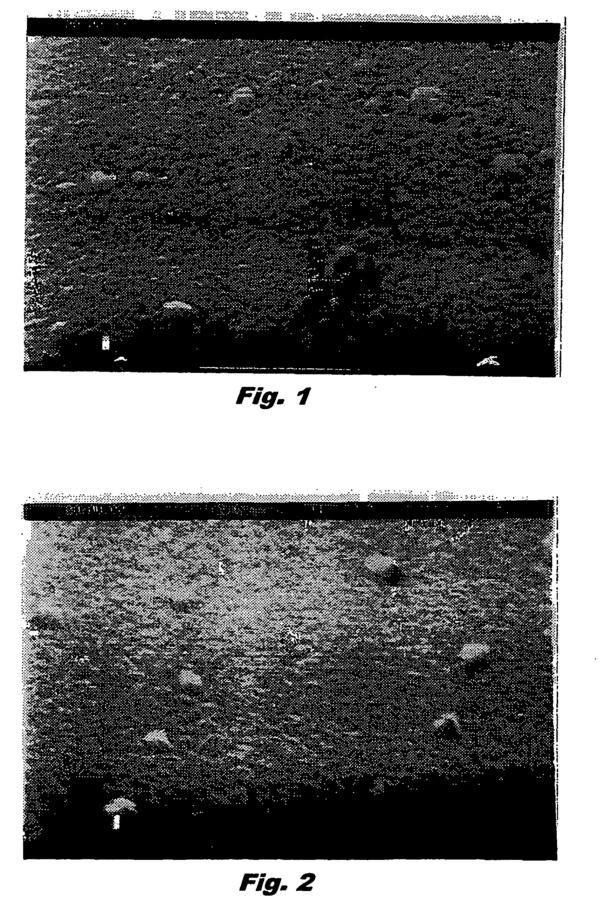

FIG. 1 is an illustration of a scanning electron micrograph of the surface of the aluminum film produced under the process parameters before annealing. FIG. 2 is an illustration of a scanning electron micrograph of the surface of the aluminum-containing film produced under the process parameters after annealing. Both FIGS. 1 and 2 show substantial hillock formation (discrete bumps on the aluminum film surface) both before and after annealing.

### EXAMPLE 2 (NOT OF THE INVENTION)

Two test samples (test sample 1 and test sample 2) of an aluminum film coating on a semiconductor substrate were fabricated using the method disclosed above. These two test samples were also formed using the Kurdex - DC sputtering system with an aluminum target depositing on a soda-lime glass substrate.

The operating procedures of the sputtering system are essentially the same as the control sample, as discussed above, with the exception that the gas content vented into the main deposition chamber included argon and hydrogen. Additionally, the pressure in the main deposition chamber during the deposition and thickness of aluminum-containing film was varied from the control sample pressure for each of the test samples.

Table 2 discloses the operating parameters of the sputtering equipment and the characteristics of the two aluminum films formed by the process disclosed above.

**TABLE 2**

| **Sputtering Process Parameters** | **Test Sample 1** | **Test Sample 2** |
|---|---|---|
| Power (KW) | 2 | 2 |
| Pressure (mtorr) | 2.4 | 2.5 |
| Gas Flow (sccm) | Argon = 90 | Argon = 90 |
| | Hydrogen = 200 | Hydrogen - 400 |

| **Characterization Parameters and Properties** | | |
|---|---|---|
| Thickness (Å) | 1600 | 1500 |
| Stress (dyne/cm²) (compressive) | -1.12x10⁸(C) | -5.6x10⁸(C) |
| Roughness (Å) (after annealing) | 800 | 540 |
| Resistivity (ΦΩ-cm) | 5.5 | 6.0 |
| Grain Size (Å) | 1000-1200 | 100-1200 |
| Hillock Density | no hillocks present | no hillocks present |

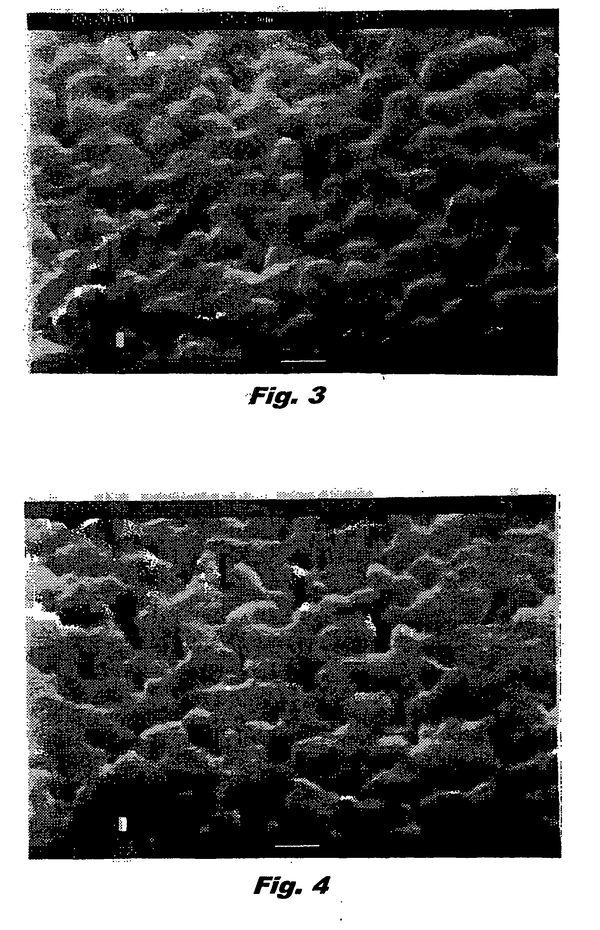

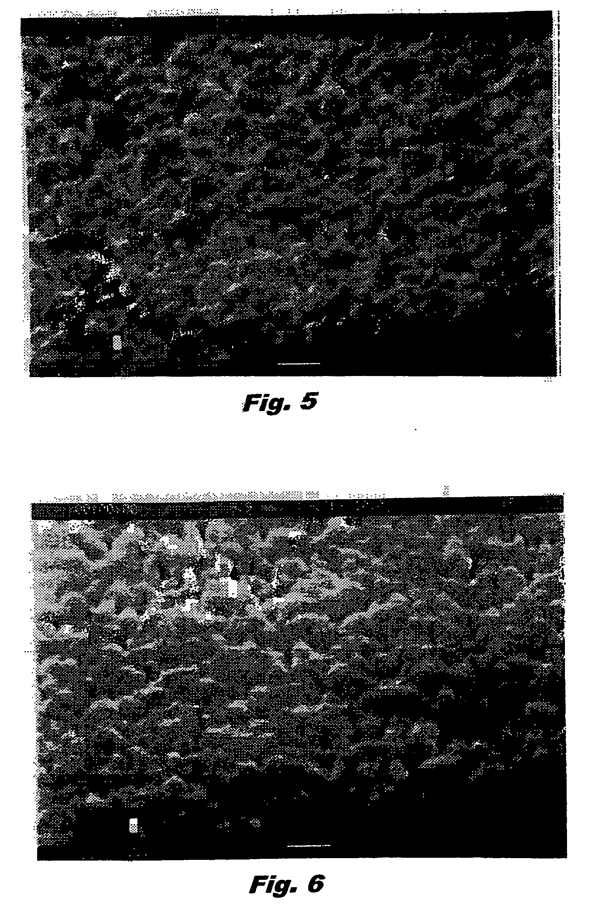

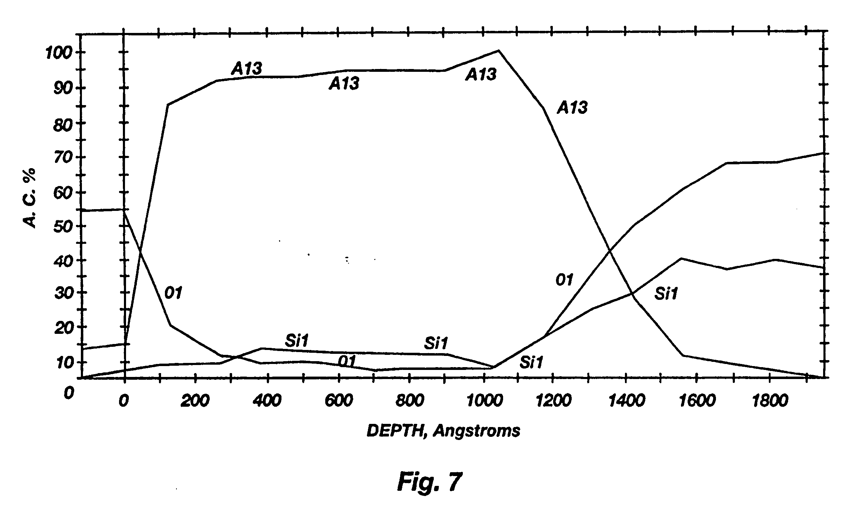

FIG. 3 is an illustration of a scanning electron micrograph of the surface of the Test Sample 1 before annealing. FIG. 4 is an illustration of a scanning electron micrograph of the surface of the Test Sample 1 after annealing. FIG. 5 is an illustration of a scanning electron micrograph of the surface of the Test Sample 2 before annealing. FIG. 6 is an illustration of a scanning electron micrograph of the surface of the Test Sample 2 after annealing. As can be seen from FIGS. 3-6, no hillocks formed on either sample whether annealed or not.

### EXAMPLES 3 (NOT OF THE INVENTION)

A number of aluminum-containing films were made at different ratios of Ar/H₂ and various system pressures were measured for oxygen content within the films. The power was held constant at 2 KW. The oxygen content was measured by XPS (x-ray photoelectron spectroscopy). The results of the measurements are shown in Table 3.

**TABLE 3**

| Sample Number | Ar/H₂ (sccm) | Ar/H₂ Ratio | Pressure (millitorr) | Oxygen Content Range (atomic %) |
|---|---|---|---|---|
| 1 | 90/400 | 0.225 | 2.50 | 5-10 |
| 2 | 90/200 | 0.450 | 2.40 | 5-10 |
| 3 | 50/90 | 0.556 | 1.27 | 3 |
| 4 | 90/90 | 1.000 | 2.15 | <1% |

An XPS depth profile for sample 3 (Ar/H₂ (sccm) = 50/90, pressure = 1.27) is illustrated in FIG. 7 which shows the oxygen content to be on average about 3% (atomic) through the depth of the film.

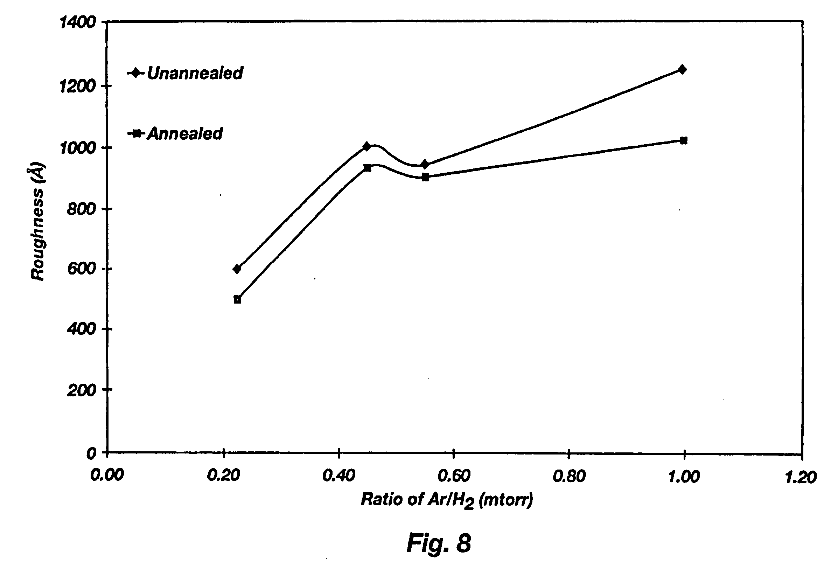

FIG. 8 illustrates the roughness of the four aluminum-containing film samples. As FIG. 8 generally illustrates, the higher the amount of hydrogen gas delivered to the sputter deposition chamber (i.e., the lower the Ar/H₂ ratio - x-axis), the smoother the aluminum-containing film (i.e., lower roughness - y-axis). It is noted that the "jog" in the graph could be experimental error or could be a result of the difference in the amount of argon introduced into the system or by the difference in the system pressure for sample number 3.

The film of the present invention is preferably produced using a conventional magnetron sputter deposition chamber within the following process parameters:

| | |
|---|---|
| Power (DC): | between about 1 and 4 KW |
| Pressure: | between about 0.5 and 2.5 millitorr |
| Argon Gas Flow Rate: | between about 25 and 90 sccm |
| Hydrogen Gas Flow Rate: | between about 50 and 400 sccm |
| Oxygen Gas Flow Rate: | between about 0.25 and 2 sccin |
| Argon:Hydrogen Gas Ratio: | between about 1:1 to 1:6 |

The operation of the magnetron sputter deposition chamber generally involves applying the direct current power between the cathode (in this case the aluminum target) and the anode (substrate) to create the plasma. The chamber is maintained within the above pressure range and an appropriate mixture of argon gas, hydrogen gas, and oxygen gas is delivered to the chamber. The aluminum-containing films resulting from this method have between about 12 and 30% (atomic) oxygen in the form of aluminum oxide (Al₂O₃) with the remainder being aluminum.

### EXAMPLE 4

Two test samples (test sample 1 and test sample 2) of an aluminum film coating on a semiconductor substrate were fabricated according to the present invention. These two test samples were also formed using the Kurdex - DC sputtering system with an aluminum target depositing on a soda-lime glass substrate.

The operating procedures of the sputtering system are essentially the same as the control sample, as discussed above, with the exception that the gas content vented into the main deposition chamber included argon, hydrogen, and oxygen (wherein oxygen is preferably introduced in an atmosphere air stream). Additionally, the pressure in the main deposition chamber during the deposition and thickness of aluminum-containing film was varied from that control sample for each of the test samples.

Table 4 discloses the operating parameters of the sputtering equipment and the characteristics of the two aluminum films formed according to the present invention.

**TABLE 4**

| **Sputtering Process Parameters** | **Test Sample 1** | **Test Sample 2** |
|---|---|---|
| Power (KW) | 2 | 2 |
| Pressure (mtorr) | 0.66 | 2.5 |
| Gas Flow (sccm) | Argon=25 | Argon=90 |
| | Hydrogen=50 | Hydrogen=200 |
| Oxygen Flow (sccm) | about 0.25 to 0.5 | about 0.25 to 0.5 |

| **Characterization Parameters and Properties** | | |
|---|---|---|
| Thickness (Å) | 2000 | 1800 |
| Stress (dyne/cm²) | 4.93x10⁸(T)* | -1.6x10⁸(C)** |
| Roughness (Å) | 980 (unannealed) 5 | 640 (unannealed) |
| | 20 (annealed) | 410 (annealed) |
| Resistivity (µΩ-cm) | 6.4 | 7.2 |
| Grain Size (Å) | 400-600 | 400-600 |
| Film Oxygen Content | approx. max. 25 % | approx. max. 20% |
| Hillock Density | no hillocks present | no hillocks present |

| | | |
|---|---|---|
| * - Tensile ** - Compressive | | |

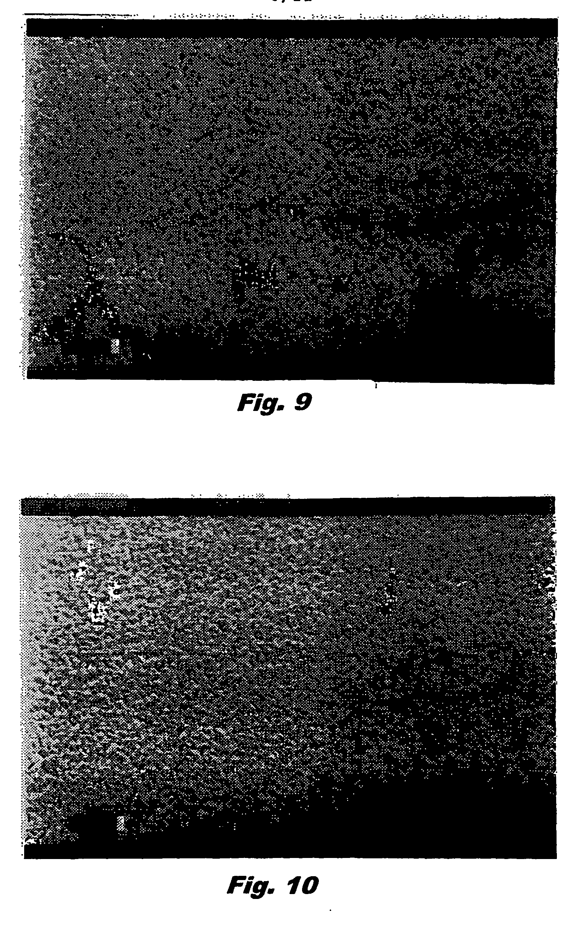

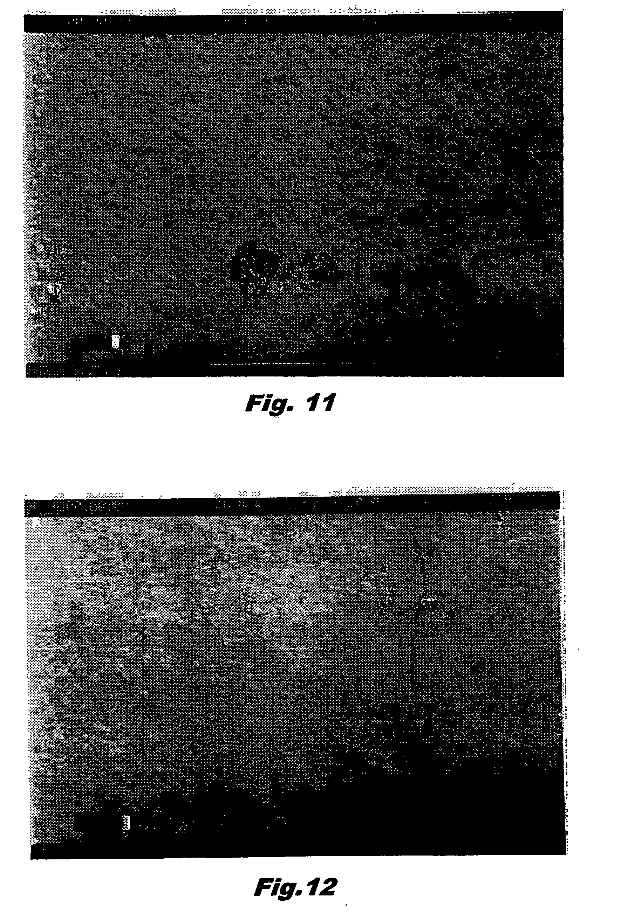

FIG. 9 is an illustration of a scanning electron micrograph of the surface of the Test Sample 1 before annealing. FIG. 10 is an illustration of a scanning electron micrograph of the surface of the Test Sample 1 after annealing. FIG. 11 is an illustration of a scanning electron micrograph of the surface of the Test Sample 2 before annealing. FIG. 12 is an illustration of a scanning electron micrograph of the surface of the Test Sample 2 after annealing. As can be seen from FIGS. 9-12, no hillocks form on either sample whether annealed or not.

### EXAMPLE 5

A number of aluminum-containing films were made at different ratios of Ar/H₂ and various system pressures were measured for oxygen content within the films. The oxygen gas flow rate was held constant at about 2 sccm and the power was held constant at 2 KW. The oxygen content was measure by XPS (x-ray photoelectron spectroscopy). The results of the measurements are shown in Table 5.

**TABLE 5**

| Sample Number | Ar/H₂ (sccm) | Ar/H₂ Ratio | Pressure (millitorr) | Oxygen Content Range (atomic %) |
|---|---|---|---|---|
| 1 | 90/400 | 0.225 | 2.50 | 12-25 |
| 2 | 90/300 | 0.300 | 2.40 | 15-30 |
| 3 | 50/200 | 0.250 | 1.50 | 15-25 |
| 4 | 25/50 | 0.500 | 0.60 | 25-30 |
| 5 | 90/50 | 1.800 | 2.10 | 15-25 |

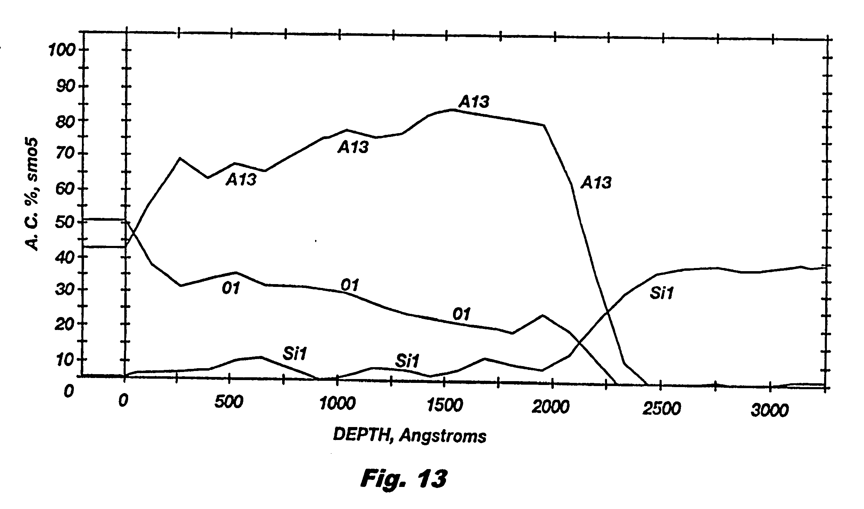

An XPS depth profile for sample 4 (Ar/H₂ (sccm) = 25/50, pressure = 0.60) is illustrated in FIG. 13 which shows the oxygen content varying on average between about 25 and 30% (atomic) through the depth of the film.

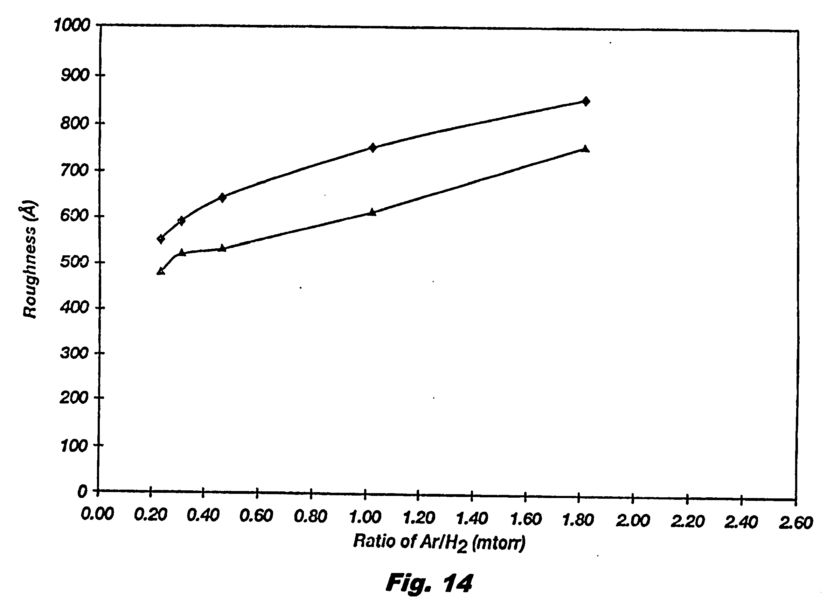

FIG. 14 illustrates the roughness of the five aluminum-containing film samples. As FIG. 14 illustrates, the higher the amount of hydrogen gas delivered to the sputter deposition chamber (i.e., the lower the Ar/H₂ ratio - x-axis), the smoother the aluminum-containing film (i.e., lower roughness - y-axis).

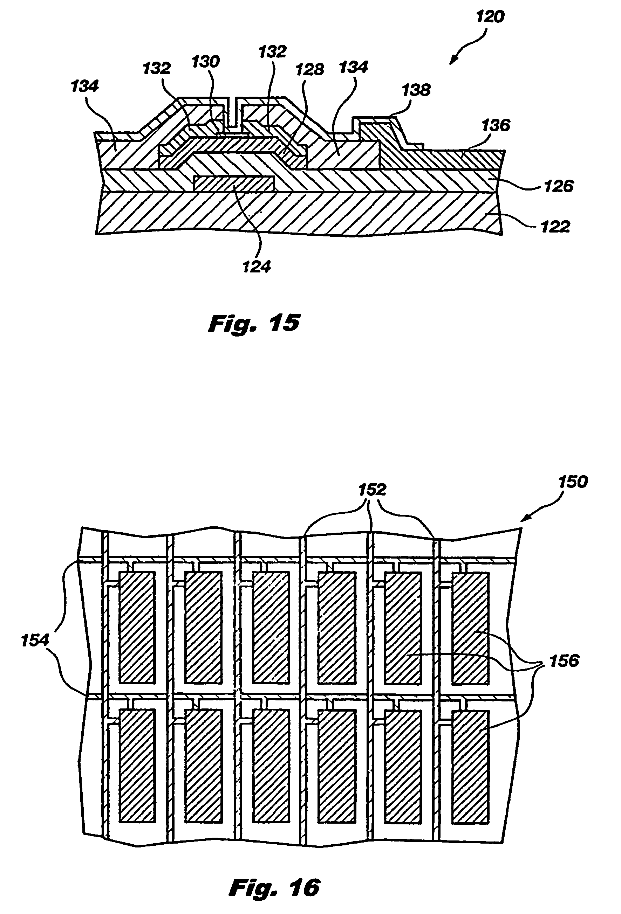

FIG. 15 illustrates a thin film transistor 120 utilizing a gate electrode and source/drain electrodes which may be formed from an aluminum-containing film of the present invention. The thin film transistor 120 comprises a substrate 122 having an aluminum-containing gate electrode 124 thereon which may be produced by a method of the present invention. The aluminum-containing gate electrode 124 is covered by an insulating layer 126. A channel 128 is formed on the insulating layer 126 over the aluminum-containing gate electrode 124 with an etch stop 130 and contact 132 formed atop the channel 128. An aluminum-containing source/drain electrode 134 which may be produced by a method of the present invention is formed atop the contact 132 and the insulating layer 126, and contacts a picture cell electrode 136. The aluminum-containing source/drain electrode 134 is covered and the picture cell electrode 136 is partially covered by a passivation layer 138.

FIG. 16 is a schematic of a standard active matrix liquid crystal display layout 150 utilizing column buses 152 and row buses 154 formed from an aluminum containing film produced by a method of the present invention. The column buses 152 and row buses 154 are in electrical communication with pixel areas 156 (known in the art) to form the active matrix liquid crystal display layout 150.

Having thus described in detail preferred embodiments of the present invention, it is to be understood that the invention defined by the appended claims is not to be limited by particular details set forth in the above description, as many apparent variations are possible without departing from the scope thereof.

## Claims

1. A semiconductor device having at least one conductive component formed from a substantially hillock-free aluminum-containing film, wherein the substantially hillock-free aluminum-containing film consists essentially of aluminum having an oxygen content of between at least 12% (atomic) and 30% (atomic) within the film.

2. A substantially hillock-free aluminum-containing film consisting essentially of aluminum having an oxygen content of between at least 12% (atomic) and 30% (atomic).

3. A flat panel display having at least one conductive component formed from a substantially hillock-free aluminum-containing film, wherein the substantially hillock-free aluminum-containing film consists essentially of aluminum having an oxygen content of between at least 12% (atomic) and 30% (atomic).

## Patentansprüche

1. Halbleiterbaustein mit wenigstens einer leitenden Komponente, die aus einer im wesentlichen hillockfreien aluminiumhaltigen Schicht gebildet ist, wobei die im wesentlichen hillockfreie aluminiumhaltige Schicht hauptsächlich aus Aluminium besteht, das einen Sauerstoffgehalt zwischen wenigstens 12% (Atomprozent) und 30% (Atomprozent) in der Schicht aufweist.

2. Im wesentlichen hillockfreie aluminiumhaltige Schicht, die hauptsächlich aus Aluminium, besteht, das einen Sauerstoffgehalt zwischen wenigstens 12% (Atomprozent) und 30% (Atomprozent) aufweist.

3. Flachbildschirm mit wenigstens einer leitenden Komponente, die aus einer im wesentlichen hillockfreien aluminiumhaltigen Schicht gebildet ist, wobei die im wesentlichen hillockfreie aluminiumhaltige Schicht hauptsächlich aus Aluminium besteht, das einen Sauerstoffgehalt zwischen wenigstens 12% (Atomprozent) und 30% (Atomprozent) aufweist.

## Revendications

1. Dispositif à semi-conducteur comportant au moins un élément conducteur formé d'un film contenant de l'aluminium pratiquement sans inégalités de surface, où le film contenant de l'aluminium pratiquement sans inégalités de surface est constitué principalement par de l'aluminium ayant une teneur en oxygène entre 12% au moins (teneur atomique) et 30% (teneur atomique) dans le film.

2. Film contenant de l'aluminium pratiquement sans inégalités de surface, constitué principalement par de l'aluminium ayant une teneur en oxygène entre 12% au moins (teneur atomique) et 30% (teneur atomique).

3. Afficheur à écran plat comportant au moins un élément conducteur formé d'un film contenant de l'aluminium pratiquement sans inégalités de surface, où le film contenant de l'aluminium pratiquement sans inégalités de surface est constitué principalement par de l'aluminium ayant une teneur en oxygène entre 12% au moins (teneur atomique) et 30% (teneur atomique)
